# EUROPEAN PATENT APPLICATION

(11) **EP 0 826 798 A2**
(43) Date of publication of application: **04.03.1998**
(21) Application number: 97306534.5
(22) Date of filing: 27.08.1997
(51) Int. Cl.: C30B 25/02, C30B 29/04, C30B 25/18

(54) **Heteroepitaxy cyclic texture growth method for diamond film**

(30) Priority: 27.08.1996 KR 9635885; 31.10.1996 KR 9651444; 01.08.1997 KR 9736859
(71) Applicant: Samsung Electronics Co., Ltd., Suwon City, Kyungki-do (KR)
(72) Inventor: Kim, Sung-hoon, Suji-eup, Yongin-city, Kyungki-do (KR); Park, Young-soo, Kiheung-eub, Yongin-city, Kyungki-do (KR); Han, In-taek, Shincheon-dong, Songpa-gu, Seoul (KR); Lee, Jo-won, Maetan-dong, Paldal-gu, Suwon-city (KR)
(74) Representative: Kyle, Diana

(57) **Abstract**

A heteroepitaxy cyclic texture growth method for a diamond film is provided. The heteroepitaxy cyclic texture growth method includes the steps of: (a) carburizing the surface of the substrate; (b) forming nuclei on the surface of the substrate; and (c) growing the nuclei formed on the substrate, wherein the step (c) is performed by a cyclic process in which mixed gas plasma state of carbon-containing gas and hydrogen gas, and hydrogen gas plasma state of hydrogen gas are alternately repeated for a predetermined duration. Therefor, coverage area of the diamond film formed on the Si-substrate is markedly increased. Also, the hydrogen gas and the mixed gas are changed into a hydrogen gas plasma state and a mixed gas plasma state, respectively, to maintain the hydrogen gas plasma state and the mixed gas plasma state for a predetermined duration, thereby increasing nucleation density of the diamond film, textured grain size of the diamond film and the degree of parallel orientation of the diamond film with respect to the substrate.

## Description

### Background of the Invention

The present invention relates to a heteroepitaxy cyclic texture growth method for a diamond film, and more particularly, to a heteroepitaxy cyclic texture growth method for a diamond film, by which grain density and area of the textured grain can be improved.

In order to manufacture an electronic device using a diamond film, a high quality diamond film and an epitaxy growth method for the diamond film are most important. Generally, the epitaxy growth method for a diamond film is classified as one of two: a homoepitaxy growth method for depositing a diamond film on a diamond substrate, and a heteroepitaxy growth method for depositing a diamond film on a heterogeneous substrate other than diamond.

However, due to the disadvantage of high costs of the diamond substrate, a commercially available diamond film has been obtained by applying the heteroepitaxy growth method to a silicon substrate of which the manufacturing process is being generalized. According to a conventional heteroepitaxy texture growth method for a diamond film, a crystalline surface {100} of the diamond film, having a desirable surface roughness, has an appropriateness with respect to the growth surface {100} of a silicon substrate, and the diamond nuclei grow in a direction along the orientation of the deposition surface of the substrate (see *Physics Review, B, 38, 4097* *(1988), K. Kobashi, N. Nishimura,* Y. *Kawate and* T. *Horiuchi).*

According to a conventional heteroepitaxy texture growth technology for a diamond film (see *Journal of Master. Res., 8, 1334 (1993), B.R. Stoner, S.R. Sahaida, J.P. Bade, P. Southworth and P.J. Ellis),* a mixture containing hydrogen gas and a carbon-containing gas is used as a plasma gas. To perform this method, a predetermined bias voltage is applied to a substrate heated to a predetermined temperature, and the mixture in which the concentrations of hydrogen gas and carbon-containing gas are properly adjusted is continuously supplied to grow a diamond thin film.

However, in the conventional heteroepitaxy texture growth method, it is difficult to improve the grain density, the area of the textured grain, and the degree of parallel orientation of the diamond film to the substrate 7.

### Summary of the Invention

To solve the above problems, it is an object of the present invention to provide a heteroepitaxy cyclic texture growth method for a diamond film, in which a cyclic nucleation step is adopted while a specific relationship between etching time and growth time during the cyclic nucleation step is defined, thereby improving the grain density and the area of the textured grain of the diamond film, and improving the degree of parallel orientation between a substrate and the diamond film.

To achieve the above object, there is provided a heteroepitaxy cyclic texture growth method for growth of a diamond film on a substrate, comprising the steps of: (a) carburizing the surface of the substrate; (b) forming nuclei on the surface of the substrate; and (c) growing the nuclei formed on the substrate, wherein the step (c) is performed by a cyclic process in which mixed gas state of carbon-containing gas and hydrogen gas, and hydrogen gas plasma state of hydrogen gas are alternately repeated for a predetermined duration.

Also, there is provided a heteroepitaxy cyclic texture growth method for a diamond film, comprising the steps of: (a) mounting a substrate in a growth chamber of an MPECVD apparatus; (b) removing impurities from the surface of the substrate by heating the substrate; (c) maintaining the internal pressure of the growth chamber within a predetermined range; (d) flowing a carbon-containing gas and a hydrogen gas into the growth chamber to form a plasma on the surface of the substrate; (e) applying a predetermined bias voltage to the substrate to form diamond nuclei on the surface of the substrate, wherein a cyclic process for alternately flowing the hydrogen gas and a gas mixture including the carbon-containing gas and the hydrogen gas into the growth chamber to maintain a hydrogen gas plasma state and a mixed gas plasma state alternately for a predetermined duration is performed; and (f) growing the diamond nuclei on the surface of the substrate.

### Brief Description of the Drawings

The above object and advantages of the present invention will become more apparent by describing in detail a preferred embodiment thereof with reference to the attached drawings in which:
FIG. 1 is a diagram showing the structure of a microwave plasma enhanced chemical vapor deposition (MPECVD) apparatus to which a gas supply device is attached, for a heteroepitaxy cyclic texture growth method according to the present invention;
FIG. 2A is an optical microphotograph showing the surface of a diamond film formed by a conventional heteroepitaxy texture growth method;
FIG. 2B is a photograph showing the surface of a diamond film formed by the heteroepitaxy cyclic texture growth method according to the present invention;
FIG. 3A is an atomic force microscopic (AFM) photograph showing the surface of the diamond film of FIG. 2A, which is formed by the conventional heteroepitaxy texture growth method;
FIG. 3B is an AFM photograph showing the grain density at the surface of the diamond film grown on a silicon (Si) substrate by the heteroepitaxy cyclic texture growth method of the present invention wherein the growth time and etching time are set to 180 and 30 seconds, respectively;
FIG. 4A is an electron microphotograph showing the gain density at the surface of the diamond film when 9 hours lapses after deposition by the conventional texture method.
FIG. 4B is an electron microphotograph showing the grain density at the surface of the diamond film when 9 hours lapses after deposition by the heteroepitaxy cyclic texture growth method of the present invention;
FIG. 5A is an electron microphotograph showing the surface of the diamond film grown on the Si-substrate for 18 hours by the conventional texture method;
FIG. 5B is an electron microphotograph showing the nucleation density of the diamond film grown on the Si-substrate for 18 hours by the heteroepitaxy cyclic texture growth method of the present invention wherein the growth time and etching time are set to 180 and 30 seconds, respectively;
FIG. 5C is an electron microphotograph showing the orientation of the diamond film grown on the Si-substrate for 18 hours by the heteroepitaxy cyclic texture growth method of the present invention wherein the growth time and etching time are set to 30 and 30 seconds, respectively;
FIG. 5D is an electron microphotograph showing the textured grain size of the diamond film grown on the Si-substrate surface by the heteroepitaxy cyclic texture growth method of the present invention wherein the growth time and etching time are set to 30 and 180 seconds, respectively;
FIG. 6 shows X-ray locking curves of the diamond film grown on the surface of the Si-substrate for 18 hours by the heteroepitaxy cyclic texture growth method of the present invention; and
FIG. 7 is a flowchart for illustrating the heteroepitaxy cyclic texture growth method for a diamond film according to the present invention.

### Detailed Description of the Invention

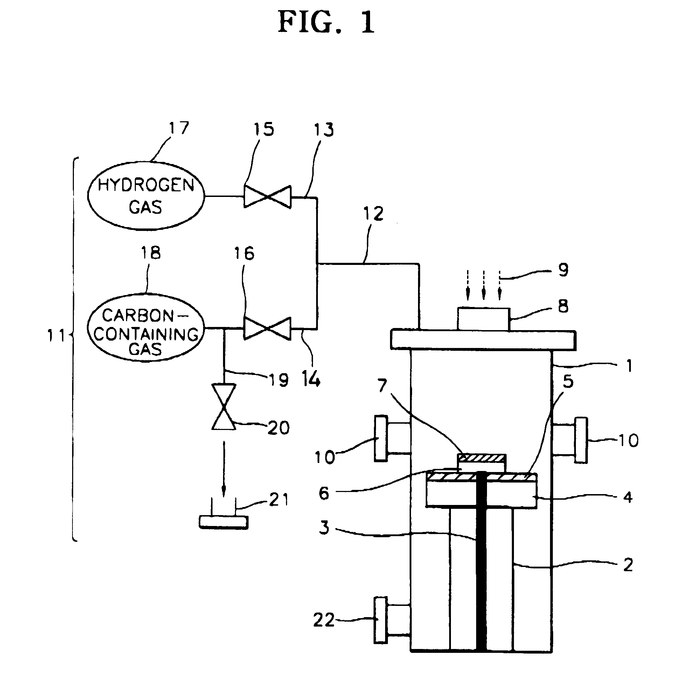

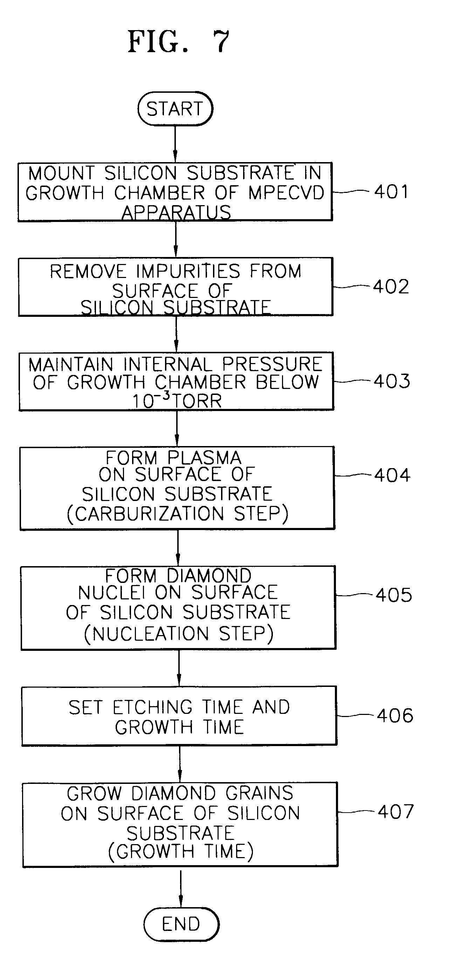

A preferred embodiment of a heteroepitaxy cyclic texture growth method for a diamond film according to the present invention will be described with reference to the flowchart of FIG. 7. Here, a microwave plasma enhanced chemical vapor deposition (MPECVD) apparatus shown in FIG. 1 is adopted.

In step 401, a silicon (Si) substrate 7 is mounted on a substrate holder 6 made of molybdenum (Mo) positioned within a growth chamber 1. Here, the temperature of the Si-substrate 7 is measured by a pyrometer (not shown) situated in the growth chamber 1, which measures the temperature by analyzing infrared rays emitted from a pyrometer.

In step 402, the growth chamber 1 is set to a hydrogen gas atmosphere using a gas supply device 11 in the initial reaction stage, and then the Si-substrate 7 is heated under the hydrogen gas atmosphere to remove impurities from the surface of the Si-substrate 7.

In step 403, an external mechanical pump (not shown) is connected to a gas outlet 22 formed the outside the growth chamber 1 to maintain the internal pressure of the growth chamber at several Torrs or less, and a gas mixture of hydrogen gas and methane gas is injected into the growth chamber 1.

In step 404, as a carburization step, methane gas and hydrogen gas are injected into the growth chamber 1 to form a plasma on the surface of the Si-substrate 7, forming a silicon carbide layer. Since diamond nuclei are not formed when the surface of the Si-substrate 7 is not scratched, carbon radicals dissociated within the plasma are diffused into the Si-substrate 7 instead of generating the diamond nuclei on the surface of the Si-substrate 7, resulting in the silicon carbide on the surface of the substrate. Here, the concentration of methane gas is maintained within a range between 0.5% and 5%, preferably at 2%, and the temperature of the Si-substrate 7 is maintained at 860°C. Also, 900W of microwave 9 is applied to the growth chamber 1 for 2 hours via the quartz window 8.

In step 405, as a nucleation step, a negative bias voltage of -200V DC is applied to the silicon substrate 7 in order to form the diamond nuclei on the surface of the Si-substrate 7. Here, the temperature of the Si-substrate 7 and the power of the microwave 9 are maintained at 860°C and 900W, respectively.

In a cyclic process for forming the nuclei, hydrogen gas is continuously injected into the growth chamber 1. Also, the injection of methane gas is controlled by periodically turning on and off the third valve 16 of the gas supply device 11. As a result, when methane gas is supplied to the growth chamber 1, the methane gas (0.5%-5%, preferably 2%) mixes with the hydrogen gas, so that the growth chamber 1 is changed into a mixed gas plasma state. Meanwhile, when the supply of methane gas is blocked, the growth chamber 1 is changed into a hydrogen gas plasma state. Also, when the supply of methane gas is blocked, the remaining methane gas which may flow into the growth chamber 1 via the third pipe line 14 is exhausted by the gas exhaust pump 21, so that the inflow of remaining methane gas into the growth chamber 1 is prevented, which is very important.

In the nuclei formation step, the "cyclic process", which refers to the repetition of a growth time and an etching time, is adopted. The cyclic process of the present invention is started in a mixed gas plasma state and completed in a hydrogen gas plasma state. Here, the duration of the mixed gas plasma state is called "growth time" in which the diamond film is grown, and the duration of the hydrogen gas plasma state is called "etching time" in which the growth of the diamond film stops (step 406).

In step 407, as a growth step, the temperature of the growth chamber 1 and the concentration of methane gas are maintained within a range between 0.5% and 5%, preferably 2%, at a temperature of 700°C, respectively, and the power of the microwave and the pressure are increased to 1000W and 25 Torr, respectively, to grow the diamond film on the Si-substrate 7. Thus, the growth of the diamond film on the Si-substrate 7 is completed.

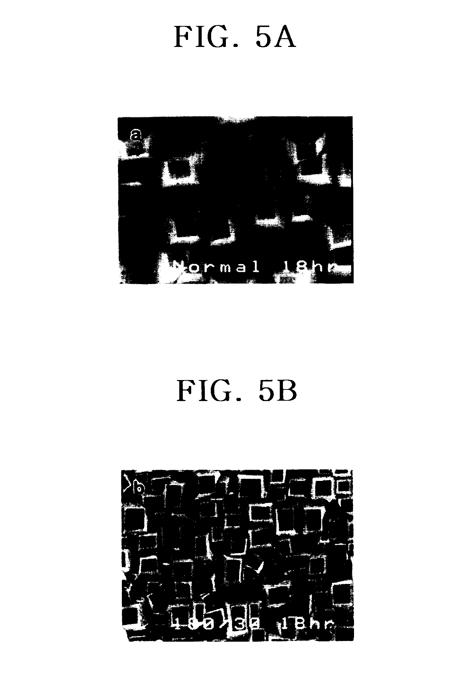

According to the heteroepitaxy cyclic texture growth method of the present invention, the growth time and the etching time are set with a predetermined relationship during step 406, so that the nucleation density of the diamond film, grain density and size of the textured grain, and the degree of parallel orientation of the diamond film to the substrate can be improved compared to the diamond film (see FIG. 5A) grown by the conventional growth method.

In order to increase the nucleation density of the diamond film deposited on the Si-substrate 7, the growth time is set to be longer than the etching time. For example, the cyclic process is controlled such that 180 seconds of the mixed gas plasma state in which methane and hydrogen are mixed and 30 seconds of the hydrogen gas plasma state are repeated for 7 minutes in the growth chamber 1 by opening and closing the third valve 16. To verify the nucleation density of the diamond film, the grain density on the surface of the diamond film, which is proportional to the nucleation density, is observed, as shown in FIG. 5B.

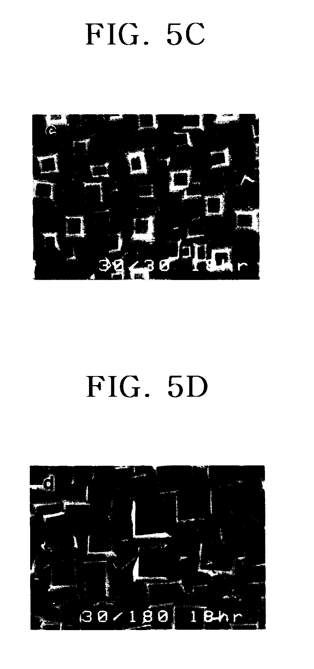

On the other hand, in order to increase the textured grain size of the diamond film grown on the Si-substrate 7, the growth time is set to be shorter than the etching time. For example, the cyclic process is controlled such that 30 seconds of the mixed gas plasma state in which methane and hydrogen are mixed and 180 seconds of the hydrogen gas plasma state are repeated for 7 minutes in the growth chamber 1 by opening and closing the third valve 16. (The structure of the diamond film grown under the above condition is shown in FIG. 5D.). Also, to improve the degree of parallel orientation of the diamond film with respect to the Si-substrate 7, the growth time and the etching time are set to be equal to each other. For example, the cyclic process is controlled such that 30 seconds of the mixed gas plasma state in which methane and hydrogen are mixed and 30 seconds of the hydrogen gas plasma state are repeated for 7 minutes in the growth chamber 1 by opening and closing the third valve 16. (The structure of the diamond film grown during the same growth and etching times is shown in FIG. 5C.).

In the above steps, hydrogen gas and carbon-containing gas each provided from supply bombs 17 and 18 pass through the second and third pipe lines 13 and 14, respectively, and then two gases are mixed in the first pipe line 12 to flow into to the growth chamber 1. However, according to circumstances, the second and third pipe lines 13 and 14 may be directly connected to the growth chamber 1, such that hydrogen gas and carbon-containing gas are each provided via the second and third pipe lines 13 and 14 are mixed within the growth chamber 1.

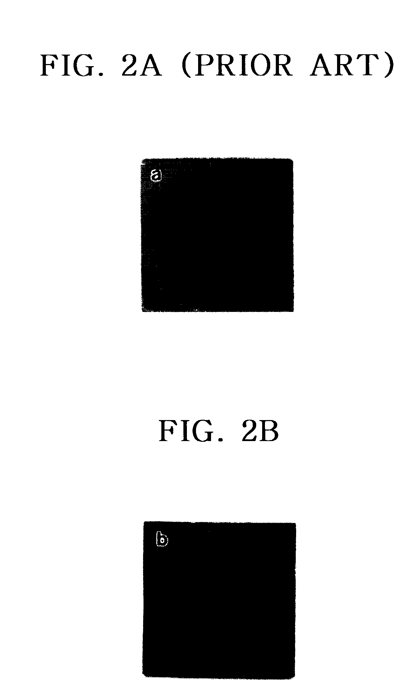

FIG. 2A is a photograph showing the surface of the diamond film passed through the nucleation step by the conventional texture growth method, and FIG. 2B is a photograph showing the surface of the diamond film passed through the cyclic process of the nucleation step by the cyclic texture growth method according to the present invention. As shown in FIGs. 2A and 2B, the area of the diamond film grown by the cyclic texture growth method according to the present invention is wider than that of the diamond film grown by the conventional method.

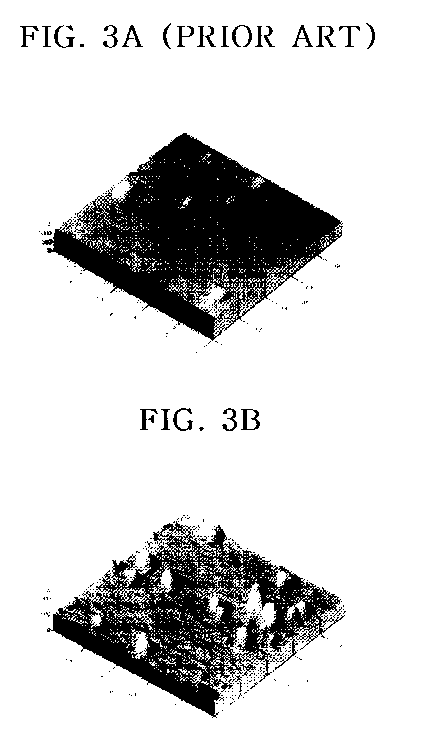

FIG. 3A is an atomic force microscopic (AFM) photograph showing the surface of the diamond film passed through the growth step for 5 minutes after the nucleation step by the conventional texture growth method, and FIG. 3B is an AFM photograph showing the surface of the diamond film passed through the growth step for 5 minutes after nucleation by the cyclic texture growth method according to the present invention. As shown in FIGs. 3A and 3B, the grain density is high in the present invention compared to the conventional method.

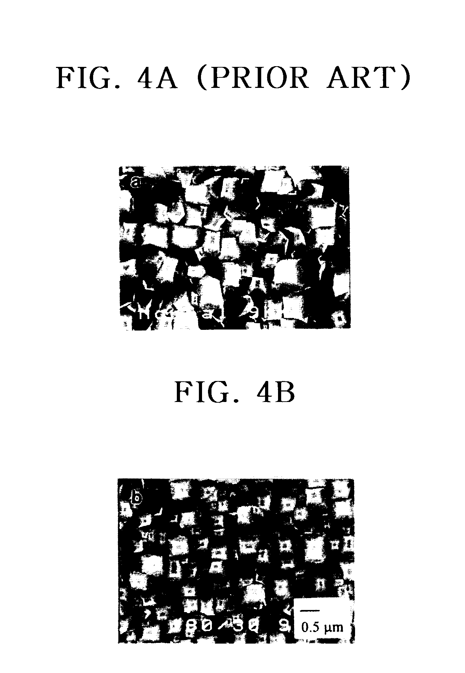

FIG. 4A is an electron microphotograph showing the surface of the diamond film completely passed through the nucleation step and the 9-hour growth step by the conventional method, and FIG. 4B is an electron microphotograph showing the surface of the diamond film completely passed through the nucleation step and the growth step by the cyclic texture growth method according to the present invention. As shown in FIGs. 4A and 4B, the grain density of the diamond film formed according to the present invention is higher than that by the conventional method as much as four times.

As shown in FIGs. 5A and 5B, when the growth time is set to be longer than the etching time in the cyclic process, the nucleation density of the diamond film increases, resulting in an increase in the grain density. Also, as shown in FIGs. 5A and 5C, when the growth time and etching time are set to be equal to each other in the cyclic process, the degree of parallel orientation of the diamond film with respect to the surface {100} of the Si-substrate 7 is improved. As shown in FIGs. 5A and 5D, when the growth time is set to be shorter than the etching time in the cyclic process, the grain density of the diamond film, that is, nucleation density, decreases while the textured grain size of the diamond film increases.

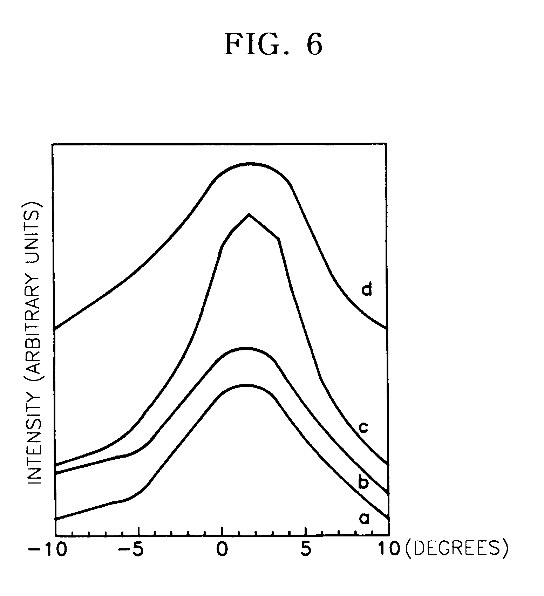

FIG. 6 shows X-ray locking curves of the diamond film grown for 18 hours on the surface {100} of the Si-substrate by the heteroepitaxy cyclic texture growth method of the present invention. Here, the horizontal axis represents theta (θ) in degrees, and the vertical axis represents intensity in arbitrary units. Also, the value of full width half maximum (FWHM) represents the degree of parallel orientation of the diamond film with respect to the Si-substrate. That is, the degree of parallel orientation becomes high as the value of FWHM decreases. In FIG. 6, "a" represents the case where the nucleation step is performed under a mixed gas plasma state by the conventional method without a cyclic process, and "b", "c" and "d" represent cases in which the heteroepitaxy cyclic texture growth method according to the present invention is adopted by controlling the growth time and etching time of the cyclic nucleation step to 180 and 30 seconds, 30 and 30 seconds, and 30 and 180 seconds, respectively. As a result, the values of FWHM of "a", "b", "c" and "d" are approximately 9.6°, 8.5°, 8.2° and 12.2°, respectively. Accordingly, when the growth time and the etching time of the cyclic nucleation step are set to be equal each other, the value of FWHM is smallest, so that the degree of parallel orientation of the diamond film with respect to the surface {100} of the Si-substrate is greatest.

The present invention is not limited to the particular forms illustrated and further modifications and alterations will occur to those skilled in the art. For example, the carbon-containing gas may be one selected from the group consisting of acetylene, ethylene, methanol, carbon monoxide and carbon disulfide, as well as methane. As the substrate, in addition to the silicon substrate, a material having a lattice constant, which is capable of forming epitaxy with the diamond film, such as copper (Cu), silicon carbide (SiC), beryllium monoxide (BeO), nickel (Ni) or graphite substrate may be used.

As described above, the heteroepitaxy cyclic texture growth method for a diamond film according to the present invention adopts the cyclic process in the nucleation step in which the growth time and the etching time are set to a predetermined duration. Therefore, the nucleation density, the grain density and the textured grain size of the diamond film, and the degree of parallel orientation of the diamond film with respect to the substrate are improved.

## Claims

1. A heteroepitaxy cyclic texture growth method for growth of a diamond film on a substrate, comprising the steps of:
(a) carburizing the surface of the substrate;
(b) forming nuclei on the surface of the substrate; and
(c) growing the nuclei formed on the substrate,
wherein the step (b) is performed by a cyclic process in which mixed gas plasma state of carbon-containing gas and hydrogen gas, and hydrogen gas plasma state of hydrogen gas are alternately repeated for a predetermined duration.

2. A heteroepitaxy cyclic texture growth method as claimed in claim 1, wherein, in the cyclic process of the step (b), a mixed gas plasma state is maintained for a longer duration than a hydrogen gas plasma state, such that the nucleation density of the diamond film grown on the substrate is increased.

3. A heteroepitaxy cyclic texture growth method as claimed in claim 2, wherein the mixed gas plasma state is maintained for 180 seconds and the hydrogen gas plasma state is maintained for 30 seconds.

4. A heteroepitaxy cyclic texture growth method as claimed in claim 1, wherein in the cycling process of the step (b), a mixed gas plasma state is maintained for a shorter duration than a hydrogen gas plasma state, such that the textured grain size of the diamond film is increased.

5. A heteroepitaxy cyclic texture growth method as claimed in claim 4, wherein the mixed gas plasma state is maintained for 30 seconds and the hydrogen gas plasma state is maintained for 180 seconds.

6. A heteroepitaxy cyclic texture growth method as claimed in claim 1, wherein in the cyclic process of the step (b), a mixed gas plasma state and a hydrogen gas plasma state are maintained for an equal duration, such that the parallel orientation of the diamond film with respect to the surface {100} of the substrate is improved.

7. A heteroepitaxy cyclic texture growth method as claimed in claim 6, wherein the mixed gas plasma state and the hydrogen gas plasma state are maintained for 30 seconds each.

8. A heteroepitaxy cyclic texture growth method as claimed in any of claims 1 to 7, wherein in the cyclic process of the step (b), the carbon-containing gas is methane gas.

9. A heteroepitaxy cyclic texture growth method as claimed in any of claims 1 to 7, wherein in the cyclic process of the step (b), the carbon-containing gas is at least one selected from the group consisting of acetylene, ethylene, methanol, carbon disulfide and carbon monoxide.

10. A heteroepitaxy cyclic texture growth method as claimed in any of claims 1 to 9, wherein the cyclic process of the step (b) is started from a mixed gas plasma state and completed by a hydrogen gas plasma state.

11. A heteroepitaxy cyclic texture growth method for a diamond film, comprising the steps of:
(a) mounting a substrate in a growth chamber of an MPECVD apparatus;
(b) removing impurities from the surface of the substrate by heating the substrate;
(c) maintaining the internal pressure of the growth chamber within a predetermined range;
(d) flowing a carbon-containing gas and a hydrogen gas into the growth chamber to form a plasma on the surface of the substrate;
(e) applying a predetermined bias voltage to the substrate to form diamond nuclei on the surface of the substrate, wherein a cyclic process for alternately flowing the hydrogen gas and a gas mixture including the carbon-containing gas and the hydrogen gas into the growth chamber to maintain a hydrogen gas plasma state and a mixed gas plasma state alternately for a predetermined duration is performed; and
(f) growing the diamond nuclei on the surface of the substrate.

12. A heteroepitaxy cyclic texture growth method as claimed in claim 11, wherein the cyclic process of the step (c) further comprises the step of:
exhausting the carbon-containing gas remaining in a supply path of the carbon-containing gas when only hydrogen gas is provided, such that the inflow of carbon-containing gas to the growth chamber is prevented.

13. A heteroepitaxy cyclic texture growth method as claimed in claim 11, wherein the cyclic process of the step (c) further comprises the step of:
separately providing the hydrogen gas and the carbon-containing gas into the growth chamber via different supply paths.

14. A heteroepitaxy cyclic texture growth method as claimed in claim 13, wherein the cyclic process of the step (c) further comprises the step of:
exhausting the carbon-containing gas remaining in a supply path of the carbon-containing gas when only hydrogen gas is provided, such that the inflow of carbon-containing gas to the growth chamber is prevented.

15. A heteroepitaxy cyclic texture growth method as claimed in claim 11, wherein in the step (a), a silicon substrate is installed as the substrate.

16. A heteroepitaxy cyclic texture growth method as claimed in claim 11, wherein in the step (a), the substrate is one selected from the group consisting of silicon carbide (SiC), copper (Cu), beryllium monoxide (BeO), nickel (Ni) and graphite substrates.
